# EUROPEAN PATENT APPLICATION

(11) **EP 3 819 031 A1**
(43) Date of publication of application: **12.05.2021**
(21) Application number: 19830553.4
(22) Date of filing: 03.07.2019
(51) Int. Cl.: B02C 19/18, B02C 19/00, B02C 23/36, C30B 15/00, C30B 29/06, H01L 21/304

(54) **METHOD FOR FRAGMENTING OR METHOD FOR PRODUCING CRACKS IN SEMICONDUCTOR RAW MATERIAL, AND METHOD FOR PRODUCING MASS OF SEMICONDUCTOR RAW MATERIAL**

(30) Priority: 04.07.2018 JP 2018127750
(71) Applicant: Mitsubishi Materials Corporation, Tokyo 100-8117 (JP)
(72) Inventor: KANAI, Masahiro, Yokkaichi-shi, Mie 510-0841 (JP); SATO, Rikito, Yokkaichi-shi, Mie 510-0841 (JP); TAKASUGI, Munehiro, Yokkaichi-shi, Mie 510-0841 (JP); UMEHARA, Koki, Yokkaichi-shi, Mie 510-0841 (JP)
(74) Representative: Plasseraud IP
(86) International application number: PCT/JP2019/026397
(87) International publication number: WO 2020/009133

(57) **Abstract**

Provided are a method of fragmenting or a method of generating cracks in a semiconductor material, and a method of producing semiconductor material lumps, which can prevent contamination from an electrode material accompanied by application of a high-voltage pulse; in a method of fragmenting or generating cracks in the semiconductor material by applying high-voltage pulse to the semiconductor material disposed in liquid, new fluid is supplied towards at least one of a part on which the high-voltage pulse is applied and a vicinity of an electrode part, and the new fluid and a part of the liquid are drawn from the liquid and discharged.

## Description

### BACKGROUND OF THE INVENTION

### Technical Field

The present invention relates to a method of fragmenting semiconductor material or a method of generating cracks in semiconductor material, and a manufacturing method of semiconductor material lumps.

Priority is claimed on Japanese Patent Application No. 2018-127750, filed July 11, 2012, the content of which is incorporated herein by reference.

### Background Art

Polycrystalline silicon used for semiconductor material is demanded to be have high purity accompanying high performance of the recent semiconductor devices. Especially, since metal impurity concentration has a large effect on performance of monocrystalline silicon, polycrystalline silicon products are demanded to have even a lower impurity level. In single crystallization of polycrystalline silicon, the CZ process is exclusively carried out. In a case in which polycrystalline silicon is used, it is fragmented and cut to fit a used size and a form is demanded to be easily handled. Therefore, in many cases machining methods by a mechanical fragmenting method or a cutting machine are applied; after the treatments, in many cases heavy metal impurities are removed by a surface cleansing using chemicals. In such a series of treatments of polycrystalline silicon, there is a problem in that a work load is increased and a yield percentage is deteriorated accompanying an increase of an amount of process.

A techniques for solving such a problem is also disclosed. For example, Patent Document 1 discloses a method of fragmenting by giving an impulse having a striking action to a silicon crystal rod. In this method, a content is shown that a preliminary treatment forming micro-cracks by a water jet pulse and shock wave is carried out as an initial stage of fragmenting and thereafter, mechanical impacts, liquid jets and shock waves are given to crystal rods; however, the details of contents to avoid contamination in the series of process are not disclosed.

Also disclosed in Patent Document 2 is a method for fragmenting rods by transmitting shock waves to semiconductor material (polycrystalline silicon rods) put in a liquid medium. In this method, the rods are disposed on a supporting body formed of a polycrystalline silicon column and immersed in water-filled bath, and the shock waves are transmitted in a state in which semi-ellipsoid reflectors are disposed to face each other. It is said that at this time, the shock is given with a certain distance from the rod to protect it from the surface contamination due to the influence of impurities.

Patent Document 3 disclose a method of fragmenting rod-shape polycrystalline silicon by disposing on a mat made of resin in treatment fluid (water) filled in a bowl and adding a high-voltage pulse from electrodes disposed in an upper part of the water. It is disclosed that contamination by foreign substances can be reduced extremely small, but the details are not disclosed. These conventional techniques have been considered to be methods that are less susceptible to contamination because both are noncontact methods of fragmenting in which the electrodes generating the shock waves are away from the fragmented objects with a certain distance.

### Citation List

### Patent Document

Patent Document 1: Japanese Unexamined Patent Application, First Publication No. H11-188281
Patent Document 2: Japanese Unexamined Patent Application, First Publication No. 2000-79350
Patent Document 3 Japanese Unexamined Patent Application (Translation of PCT International Application), Publication No. 2017-515774
Patent Document 4 Japanese Unexamined Patent Application (Translation of PCT International Application), Publication No. 2014-528355

### SUMMARY OF INVENTION

### Technical Problem

However, it is disclosed in the conventional methods that, in a case in which the electrode parts applying the shock waves (the high-voltage pulse) and the fragmented objects are in the same liquid medium, micro particles and ions generated from the fragmented objects by the shock when the high-voltage pulse is added are removed from the vicinity of the electrode parts by supplying the process liquid to a region between the electrodes and the fragmented material and between the electrodes, and energy efficiency when the shock waves are added is maintained by reducing or constantly maintaining electrical conductivity of the process liquid (in Patent Document 3 and Patent Document 4). By such a method, it is also possible to stabilize crushing efficiency by supplying/discharging the process liquid to maintain the electrical conductivity of the process liquid to be lower than a certain value; however, an influence of the electrode parts by applying the shock wave, especially an influence of contamination and the like generated from electrode members is not considered.

As described above, by adding the shock waves to the fragmented objects in a state in which the electrode part adding the shock waves and the fragmented objects were in the same liquid, it was confirmed that a part of the electrodes gradually deteriorated accompanying increasing of the adding number of times and derived and spread in the liquid medium as abrasion chips, so that contamination of the fragmented objects occurred by the abrasion chips of the electrode parts. Particularly, there is a case in which minute cracks are formed on a surface of the semiconductor material when the high-voltage pulse is applied, and it is considered that a part of the abrasion chips of the electrode material spread into the liquid medium is taken into the minute cracks, so that the contamination occurs. The impurities such as the abrasion chips of the electrode material and the like are difficult to be removed perfectly if they are once taken into the minute cracks, even by performing an etching treatment and the like using chemicals thereafter; and it is difficult to maintain or improve the quality.

Accordingly, it is difficult to maintain the quality of the fragmented objects by cleansing using the process liquid on regions between the electrodes and between the electrodes and the fragmented objects as disclosed in Patent Document 3 and Patent Document 4. The contamination is a problem that must be solved in a case of the polycrystalline silicon used for mono-crystallizing as above-described in accordance with a demand of high purity.

The present invention is achieved in consideration of the above circumstances, and has an object to provide a method of fragmenting semiconductor material or a method of generating cracks thereof, and a method of producing semiconductor material lumps which can reduce contamination by abrasion chips of electrode parts accompanying application of high-voltage pulse.

### Solution to Problem

A method of fragmenting or generating cracks in semiconductor material of the present invention is in a method of fragmenting the semiconductor material or a method of at least generating cracks by applying high-voltage pulse on the semiconductor material disposed in liquid, when the high-voltage pulse is applied, new fluid is continuously supplied toward at least one of a part on which the high-voltage pulse is applied in the semiconductor material and the electrode parts.

According to the method of fragmenting the semiconductor material or the method of generating cracks, a continuous stream is formed by the new fluid around the part on which the high-voltage pulse is applied in the semiconductor material and the vicinity of the electrode parts including thereof. This stream is a stream (a carrier flow) conveying abrasion chips of the electrode parts deriving and spreading into the liquid when the high-voltage pulse is applied. That is to say, by generating the carrier flow of the new fluid around the electrode parts, the vicinity of the electrode parts and the application part of the high-voltage pulse, the abrasion chips accompanying the high-voltage pulse spread from the vicinity of the electrode parts into the liquid are removed with efficiency from the part of the semiconductor material on which the high-voltage pulse is applied and the vicinity of the electrode parts. Thereby enabling to reduce a possibility of a part of the electrode parts taken into the minute cracks generated on the surface of the semiconductor material. As a result, the semiconductor material can be prevented from the contamination from the electrode parts accompanying the application of the high-voltage pulse.

In the present invention, the cracks are different from the above-described minute cracks, for example, they are cracks generated into the deep part so that the shape thereof is divided and getting to fragmentation by small impact by a hammer or the like; on the other, the minute cracks are small cracks which are generated on the surface of the semiconductor material with a length of less than a few mm but not cracked into the deep part.

As one aspect of the method of fragmenting or the method of generating cracks in semiconductor material, it is preferable that the new fluid is continuously supplied and at least a part of the new fluid after supplied to at least one of a part of the semiconductor material on which the high-voltage pulse is applied and the electrode parts, and a part of the liquid be drawn and discharged.

Thereby a stream (a carrier flow) forcibly conveying the abrasion chips even in a case in which the abrasion chips of the electrode parts derived accompanying the application of the high-voltage pulse are spread into the liquid is continuously generated, so that they can be effectively prevented from adhering on and taken into the semiconductor material continuously.

In a case in which the electrode material is removed from around the semiconductor material or electrode parts, when the high-voltage pulse is applied several times, a ratio of including the electrode material in the vessel in which the liquid is contained is gradually increased; accordingly, it is desirable to discharge the fluid discharging the electrode material from the liquid to the outside of the system. Specifically, it is desirable to provide a discharging port at an opposite position to a supplying port of the new fluid and to discharge continuously by sucking or the like. In this case, a part of liquid filled in the vessel is also discharged with the fluid.

That is to say, one aspect of the method of fragmenting or the method of generating cracks in semiconductor material desirably discharges at least a part of the new fluid with the liquid to the outside of the system after the new fluid is supplied to a part on which the high-voltage pulse is applied or the electrode parts or the semiconductor material after fragmented.

In another aspect of the method of fragmenting or the method of generating cracks in semiconductor material, the new fluid is supplied to the semiconductor material after the high-voltage pulse is applied or fragmented.

The abrasion chips of the electrode parts derived and spread into the liquid by the application of the high-voltage pulse may also spread around the semiconductor material after the cracks are generated or fragmented; therefore, when the semiconductor material is fragmented by the application of the high-voltage pulse, in a case in which the minute cracks are generated on the surface, there is a possibility in the abrasion chips to be taken into the minute cracks. Therefore, by supplying the new liquid to the semiconductor material after the application of the pulse or the fragmentation, it is possible to effectively prevent the contamination resulting from the abrasion chips of the electrode parts taken into the minute cracks.

It is possible to prevent the contamination by the electrode material more effectively by continuously supplying the new liquid.

As another aspect of the method of fragmenting or the method of generating cracks in semiconductor material, it is preferable that at least a part of the new fluid be flowed in a direction different from a direction toward the semiconductor material in an imaginary line in which a distance between a tip end of the electrode parts and the semiconductor material is minimum.

The electrode parts are disposed opposing to the semiconductor material with a prescribed space; and in the semiconductor material the cracks are generated or the fragmentation occurs by the shock wave by the application of the high-voltage pulse from the electrode parts. At this time, depending on the arrangement of the electrode parts, for example, in a case in which regions of the semiconductor material where the fragmentation or the cracks are generated is in the same direction as the arrangement direction of the electrode parts or a case in which it is the same direction as the generation direction of the shock wave, the above-mentioned abrasion chips generated from the electrode parts spread to the regions, so that the possibility in that the abrasion chips are taken in the minute cracks generated on the surface of the semiconductor material is high. Therefore, to make the direction different from the direction of the generation of the high-voltage pulse in the fluid, the carrier flow is generated so as to supply the new fluid in the direction different from the direction toward the semiconductor material in the imaginary line in which the distance between the tip end of the electrode parts and the semiconductor material is minimum; thereby it is possible to prevent the abrasion chips from being taken into the minute cracks on the surface of the semiconductor material accompanying the application of the high-voltage pulse more efficiently.

As further another aspect of the method of fragmenting or the method of generating cracks in semiconductor material, the liquid and the new fluid are preferably water or pure water.

The liquid and the new fluid are easily handled if they are water or pure water. Preferably, by using pure water it is possible to fragment in the liquid with higher purity, and the influence of the contamination by impurities other than the electrode material can be also prevented. More preferably, also ultrapure water may be used as the liquid and the new fluid.

As further another aspect of the method of fragmenting or the method of generating cracks in semiconductor material, the liquid and the fluid may include bubbles.

It is preferable that the liquid in which the semiconductor material be disposed be in a bubble-spread state. Moreover, the bubbles are preferably fine bubbles (e.g., bubbles having a diameter of 100 µm or less). The fine bubbles are in the bubble-spread state in the liquid, so an effect of absorbing the electrode material on the surface of the fine bubbles scattering in the liquid when the high-voltage pulse is applied can be expected. Even in a case in which the fine bubbles exist in a spread state in the new fluid, the similar effect can be expected.

Moreover, by including the fine bubbles in the liquid or the new fluid, the bubbles are collapsed by the application of the high-voltage pulse, an effect of reducing the adhesion of the electrode material on the surface of the semiconductor material can be expected by the shock wave generated around the fine bubbles.

The semiconductor material may be polycrystalline silicon to be raw material for producing monocrystalline silicon. By the above-mentioned method, since the influence of the abrasion chips of the electrode parts is small and the fragmentation reducing the influence of the contamination can be performed, it is possible to provide polycrystalline silicon with high quality as raw material for producing monocrystalline silicon.

A method of manufacturing semiconductor material lumps of the present invention includes a forming step of a rod-shape material forming semiconductor material into a rod; and a fragmenting step fragmenting the semiconductor material by any one of the above mentioned fragmenting method or fragmenting the semiconductor material by a mechanical method after cracks are generated, into semiconductor material lumps.

In addition, in the method of manufacturing semiconductor material lumps, in order to obtain the semiconductor material lumps having a prescribed fragment size, the semiconductor material may be fragmented by repeating the fragmenting method by the application of the high-voltage pulse.

### Advantageous Effects of Invention

According to the present invention, it is possible to efficiently prevent the contamination from the electrode parts accompanying the application of the high-voltage pulse of the semiconductor material.

### BRIEF DESCRIPTION OF DRAWINGS

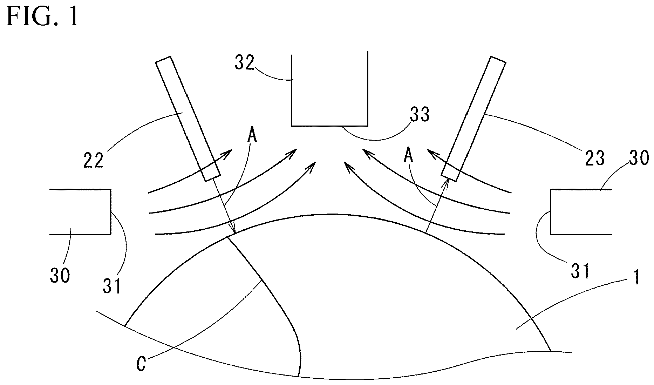

FIG. 1 is a function drawing of a fragmenting method of semiconductor material.

### DESCRIPTION OF EMBODIMENTS

An embodiment according to the present invention will be explained with referring a drawing.

FIG. 1 is a function drawing of a fragmenting method or a method of generating cracks of semiconductor material.

In the fragmenting method or the generating cracks of semiconductor material according to the present embodiment, a silicon rod (semiconductor material) 1 is disposed in liquid. In the present embodiment, high-voltage pulse is applied from a tip of one electrode part of two electrode parts 22 and 23, e.g., the electrode part 22, so that an insulation breakdown is generated between the silicon rod 1 and the electrode part 22; and shock waves are generated, and transmitted through the silicon rod 1. By the shock waves, a crack C is generated in the silicon rod 1, or the silicon rod 1 is fragmented. By grounding the other electrode part 23, the applied high-voltage pulse flows into the electrode part 23; and a part of the high-voltage pules flows to the ground by surface transmission between the electrode parts 22 and 23.

Although it is not necessarily limited, the silicon rod 1 on which this fragmenting method is applied is disposed in a prescribed vessel in a state of being insulated from the vessel, and prepared in a state of being soaked in liquid. Although the shape of the silicon rod 1 is not especially restricted, an arrangement is preferable so that a distance between the electrodes and the silicon rod 1 be in a prescribed range in order to apply the high-voltage pulse in a certain state. For example, it is preferable to dispose mutually to have substantially a constant distance of top end sides of the electrodes with respect to a side surface of a major axis of the rod. A size of the silicon rod that can be relatively easily handled is, for example, a diameter is about 50 mm or more and about 200 mm or less and a length is about 30 cm or more and about 2000 cm or less. A distance from the electrode parts 22 and 23 to the surface of the silicon rod 1 is preferably about 2 mm or more and about 50 mm or less; and a distance between the electrode parts 22 and 23 is preferably about 30 mm or more and about 100 mm or less. It is preferable that a voltage of the applied high-voltage pulse be about 100 kV or more and 300 kV or less, power per one pulse be 300 J or more and 1000 J or less, and frequency of the high-voltage pulse be about 0.5 Hz or more and 40 Hz or less.

Setting value of the above-described fragmenting setting condition can be modified according to the configuration of the equipment: it is preferable to set appropriately considering the form and the size of the fragmented objects, while forming the fragmented object or forming the cracks.

Into the liquid, by the shock when the high-voltage pulse is applied, a part of the electrode parts 22 and 23 is derived as abrasion chips and spread to the vicinity of the electrode parts 22 and 23 and to the part to which the high-voltage pulse is applied of the silicon rod 1. The derivation and the spread of the abrasion chips of the electrode parts are increased with increasing of the number of applying times.

Therefore, new fluid is supplied to at least one of the part to which the high-voltage pulse is applied of the silicon rod 1 and the electrode parts 22 and 23. FIG. 1 shows a state of supplying the new fluid toward the electrode parts 22 and 23 and toward an electric discharging region applied on the surface of the silicon rod 1: supplying ports 31 of supplying nozzles 30 for supplying the new fluid and a discharging port 33 of a discharging pipe 32 are disposed in the vicinity of the electrode parts 22 and 23 and a region on which the high-voltage pulse is applied, so that the new fluid is continuously supplied. Thereby the abrasion chips derived from the electrode parts 22 and 23 are removed from the part to which the high-voltage pulse is applied and the vicinity of the electrode parts 22 and 23.

The supplying nozzles 30 for the new fluid and the discharging pipe 32 are preferably disposed to have a certain distance from the electrode parts 22 and 23 and the high-voltage pulse applied part so as not to be influenced from the electric discharge accompanying application of the high-voltage pulse applying.

Thereby, a successive flow of the new fluid is generated around the part to which the high-voltage pulse is applied and the vicinity of the electrode parts 22 and 23 as shown by the solid arrows. This flow becomes a flow (a carrier flow) carrying the abrasion chips of the electrode parts derived accompanying the application of the high-voltage pulse; and the abrasion chips are removed with the flow from the part to which the high-voltage pulse is applied and the vicinity of the electrode parts 22 and 23. As a result, it is possible to prevent the contamination by the abrasion chips taken into the minute cracks formed on the surface of the silicon rod 1.

In this case, the new fluid flows in a different direction from a direction of the high-voltage pulse applied from the electrode part 22 (a direction from the tip of the electrode part 22 toward the silicon rod 1, a direction from the silicon rod 1 toward the electrode part 23). Specifically, it is preferable to supply the liquid in a different direction from a direction (a direction shown by the arrow A in FIG. 1) from the electrode parts 22 and 23 toward the silicon ingot 1 in an imaginary line in which the distance from the tips of the electrode parts 22 and 23 to the silicon ingot 1 is shortest, in order that the direction of the generation of the high-voltage pulse and the flow direction of the flow are different directions. The abrasion chips generated from the electrode parts 22 and 23 (especially the electrode part 22) accompanying the application of the high-voltage pulse go toward the silicon rod 1 side along with the shock wave; in a process of fragmenting the silicon rod 1 or generating cracks, they cause the contamination by being taken into the minute cracks generated on the surface. Therefore, the abrasion chips derived from the electrode parts 22 and 23 can be kept away from the silicon rod 1 by generating the flow of the new fluid successively in the different direction from a direction of electric field, and the contamination can be avoided or reduced. The supplying ports 31 and the discharging port 33 may be disposed to face each other.

In this case, in order to efficiently supply the liquid, it is desirable to dispose the supplying ports 31 in the vicinity of the part of the silicon ingot 1 to which the high-voltage pulse is applied or the vicinity of the electrode parts 22 and 23; however, there is a case of occurring damages and abrasion of the supplying ports 31 by being influenced of the shock wave accompanying the application of the high-voltage pulse, it is prone to be influenced by the contamination of the material of the supplying ports 31 of the new fluid and the material contamination of the new fluid itself. Therefore, it is desirable that the arrangement of the supplying ports 31 of the new fluid is an arrangement in a state with a certain distance from the part to which the high-voltage pulse is applied or the electrode parts 22 and 23.

It is desirable to decide a discharging amount in accordance with a supplying amount of the new fluid. Since the abrasion chips of the electrode parts in the vessel is relatively increased if the supplying amount of the new fluid is more than the discharging amount, it is desirable that the discharging amount is at least the same as the supplying amount or more than the supplying amount.

In a case in which the discharging amount is more than the supplying amount, since a liquid amount in the vessel is gradually reduced, it is desirable to supply the liquid into the vessel in a case in which the liquid amount is less than a certain amount in order that the whole silicon rod 1 is soaked or the electrode parts are soaked in the liquid so as to be at least a state in which the high-voltage pulse can be applied.

The supplying amount of the new fluid is, although it depends on an applying condition of the high-voltage pulse, preferably 90 L/min. or more, more preferably 100 L/min. or more. If the supplying amount of the new fluid is small, it may prone to rise the influence of the contamination on the surface of the fragmented objects by the spread of the abrasion chips since the spread of the abrasion chips of the electrode parts accompanying the application of the high-voltage pulse is more than engulfing by the flow of the new fluid.

In this embodiment, also after the cracks are formed or the silicon rod 1 is fragmented, by supplying the new fluid successively to the fragmented objects or cracked objects so as to generate the flow therearound, the spreading abrasion chips of the electrode parts 22 and 23 are removed by the carrier wave, and a probability of taken into the minute cracks generated when the high-voltage pulse is applied is even more reduced. As a result, also in the semiconductor material lumps after forming cracks or fragmented, the contamination by the abrasion chips derived from the electrode parts is effectively reduced.

The fluid is easy to be handled since it is water or pure water; it is possible to fragment under supplying high-purity liquid or fluid using pure water, furthermore, an influence by impurities other than the electrode material can be reduced.

If the liquid or the new fluid in which the silicon rod 1 is disposed has bubbles, the bubbles collapse by the application of the high-voltage pulse, so that the abrasion chips are even more difficult to be taken into the minute cracks by the shock and the like, and an effect of reducing the adhesion on the surface of the semiconductor material lumps after fragmenting can be expected.

Furthermore, diffusing the minute bubbles with a diameter of 100 µm or less evenly in the liquid in which the silicon rod 1 is disposed or the fluid which is newly supplied, an effect of floating and diffusing by an absorbing the abrasion chips of the electrode material on the surface of the minute bubbles can be expected. It is expected to obtain the same effect also by existing the minute bubbles in the water and the pure water in an even diffused state. It is more desirable that the minute bubbles are bubbles of nano level (nm).

Next, explained is a method of producing the semiconductor material lumps to be the material for producing monocrystalline silicon using the above-described fragmenting method or the crack generation method.

The producing method of the semiconductor material lumps according to the present embodiment includes as a main process: a making step of a rod-shape material making the rod-shape silicon rod 1 by deposition of silicon in a furnace; and a fragment step by fragmenting by the fragmenting method described above or fragmenting after at least cracks are generated to make the silicon rod 1 to the semiconductor material lumps. Furthermore, it includes a cleansing step, a drying step, a packaging step and the like performed on the semiconductor material lumps after the fragment step.

In the making step of a rod-shape material, the silicon rod 1 is obtained by touching material gas containing chlorosilane gas and hydrogen to a heated silicon core rod to deposit silicon on the surface in substantially a columnar shape.

In the fragment step, the semiconductor material lumps are obtained by fragmenting the silicon rod 1 by the above-described method or fragmenting after at least cracks are generated. The fragmented silicon rod 1 is used which is preferably cleansed by pure water in advance. More preferably, one may be used in which surface impurities are removed by etching by chemicals.

The semiconductor material lumps obtained by this fragment step are fragmented by the shock wave by the application of the high-voltage pulse, and can be formed in lumps having a desired size by settings or the like such as the applied voltage, the applied recovery, a distance between the electrodes and the semiconductor material lumps. Thereby, it is not necessary to use a hammer or a mechanical fragmenting device thereafter; or even in a case of using the hammer or the mechanical fragmenting device, it can be managed with a minimum use to fragment a lump in which a crack is generated, so that it is relatively easy to fragment and a fragmenting workload is small, so that a contact with the metal material accompanying fragmenting can be small and the metal contamination can be reduced.

When fragmenting, the electrode part 22 and 23 and the silicon rod 1 are relatively moved in a diameter direction and a length direction of the silicon rod; it is preferable that 0.5 pulse or more and 1.0 pulse or less be applied per 1 mm of the relative movement.

The cleansing step is a step of removing impurities adhered on the surface of the semiconductor material lumps using chemicals such as acid and washing the acid away by pure water.

In the drying step, the semiconductor material lumps washed by the pure water are put in a dryer to dry them.

In the packaging step, the semiconductor material lumps are inspected in size and appearance, and stored in a packaging bag made of resin (e.g., made of polyethylene).

In the producing method of the semiconductor material lumps of the present embodiment, the cracks are generated in the silicon rod 1 to fragment them by the above-mentioned fragmenting method; so that the purity of the fragmented polycrystalline silicon lumps can be maintained high. Accordingly, the semiconductor material lumps obtained by this method can maintain the quality of monocrystalline silicon produced from them.

The embodiment is an example of providing one supplying port of the new fluid; by providing a plurality of supplying ports and a plurality of supplying direction, the new fluid can be more efficiently supplied to the part of the semiconductor material where the high-voltage pulse is applied and the like.

### [Examples]

### ---Example 1---

Table 1 shows a result of confirming states of derivation and spreading of the abrasion chips from the electrode parts accompanying the application of the high-voltage pulse.

The state of generation of the abrasion chips of the electrode parts in pure water by the application of the high-voltage pulse was confirmed by inserting the electrode parts (an electric voltage application part, a ground part) in the pure water filled in a vessel. The applied voltage was about 170 kV and the distance between the electrodes was about 100 mm. Polycrystalline silicon material was not used; only the electrode parts were soaked in the pure water. Confirmed were two cases in which the new fluid (pure water) was supplied to the electrode parts in the vessel and in which the new fluid was not supplied. The pulse application was performed 10 times.

The abrasion chips were confirmed by analyzing concentration of the electrode material respectively in the pure water collected in the vicinity of the electrode parts about one minute after the high-voltages pulse was applied and in the pure water within the vessel distant from the electrode parts after the high-voltage pulse was applied. In a case in which the new fluid (pure water) was supplied, the pure water in the vicinity of the electrode parts was collected in a position opposite to the fluid supplying position with the electrode parts therebetween.

The concentration of the electrode material in the collected pure water was measured by a method of ICP emission spectrochemical analysis (inductive coupling plasma emission spectrometry).

The concentration of the electrode material in the pure water in the vessel before the application of the high-voltage pulse was less than 1.0 ppbw.

**[Table 1]**

| | New Fluid Not Supplied (ppbw) | New Fluid Supplied (ppbw) |
|---|---|---|
| Vicinity of Electrode Parts | 56 | 50 |
| Inside Vessel | 41 | 12 |

By applying the high-voltage pulse, a part of the material (the abrasion chips) of the electrode parts from the electrode parts was derived in the vicinity of the electrode parts and spread along with the application of the pulse; although a degree of the spread was uneven, it was confirmed that the concentration of the electrode material in the vicinity of the electrode parts was higher comparing with that in a position at a distant from the electrode parts in the vessel. In the case, as shown in Table 1, by supplying the new fluid, it is inferred that the abrasion chips derived around the electrode parts are moved along with the flow of the fluid from the vicinity of the electrode parts, so that the concentration of the electrode material in the pure water is reduced. Since it can be appeared that the spread of the derived abrasion chips from the vicinity of the electrode parts to the whole inside the vessel is reduced by forming the flow of the fluid, it can be found it is effective for prevention of contamination to the semiconductor material.

When supplying the above-described new fluid, pure water was injected at about 20 L/min. using a blade hose made of resin.

Regarding the abrasion chips derived from the electrode parts in the high-voltage pulse fragmentation in the present example, the size was several µm in a confirmation of collecting by filtering by a filter; and it was also found that hydroxide of oxide of the electrode material (hydroxide of iron oxide FeO) was included in the confirmation of the collected abrasion chips by Raman spectroscopy.

### ---Example 2---

Table 2 shows a result of confirming a state of contamination on the surface of fragmented material accompanying the application of the high-voltage pulse.

A rod-shape polycrystalline silicon material block with a diameter of about 110 mm and a length about 1000 mm was soaked in pure water filled in the vessel; the high-voltage pulse was applied on the material block at a condition of voltage of about 170 kV, a distance between fragmented material and the electrodes of about 30 mm, a frequency of 1 Hz; and a degree of contamination of electrode parts material contamination was confirmed on the surface of silicon after the application (after fragmenting). The new fluid (pure water) was supplied to the pulse application part, the electrode parts and the fragmented material (before and after the fragmentation) with a prescribed amount (about 90 L/min.).

The new fluid (pure water) had two patterns of (1) a case supplying to the electrode parts and therearound and (2) a case supplying both to the electrode parts and therearound and the material after fragmentation; and concentration of the fragmented material was measured respectively in a case in which the supplied fluid was drawn and removed and a case in which the supplied fluid was not drawn and not removed. The pure water was collected at a position opposite to the fluid supplying position with intervening the electrode parts; in a case in which the supplied fluid was drawn and removed, it was downstream of the position of drawing and removing.

Concentration of contamination of the electrode part material on the surface of the fragmented material was analyzed by ICP-MS method (inductive coupling plasma mass spectrometry) after fragmenting.

The number of samples was three (n=3); the minimum value and the maximum value were shown.

**[Table 2]**

| | Not Drawn and Removed | | Drawn and Removed | |
|---|---|---|---|---|
| Position of Supplying New Fluid | (1) | (2) | (1) | (2) |
| Concentration of Fragmented Material (ppbw) | 0.021-0.055 | 0.020-0.045 | 0.010-0.018 | 0.008-0.013 |

From the result of Table 2, the result was that the contamination on the surface of the material lumps was uneven and the degree thereof was high by discontinuously supplying pure water comparing to by continuously supplying fluid.

### ---Example 3---

Table 3 shows a result of confirming the state of contamination on the surface of the fragmented material in a case in which bubbles (nano bubbles) were included in the liquid and the new fluid.

The condition of the application of the high-voltage pulse was the same as in Example 2; the new liquid was supplied at the same condition as in Example 2 to both the electrode parts and therearound and the material after fragmenting; the pure water was drawn and removed at the opposite side position to the fluid supplying position with intervening the electrode parts; and then the fragmented polycrystalline silicon was taken out from the vessel and dried, and the concentration of the electrode material on the surface of silicon was measured as in Example 2.

The number of samples was three (n=3); the minimum value and the maximum value were shown.

**[Table 3]**

| | Bubbles included |
|---|---|
| Concentration of Fragmented Material (ppbw) | 0.010-0.015 |

As known from Table 3, in the fragmentation by the application of the high-voltage pulse using the liquid and the new fluid including the bubbles it was confirmed that there was effect of reducing the influence of the contamination of the abrasion chips of the electrode parts comparing with a case in which the bubbles were not included.

### --- Example 4---

Table 4 shows the result of confirming a state of contamination on the surface of the fragmented material depending on the supplying direction of the new fluid.

The liquid and the new liquid were pure water; the electrodes and the semiconductor material were soaked in the pure water; and the high-voltage pulse was applied on the semiconductor material via the electrodes to fragment it. A polycrystalline silicon rod (about 1.5 m, a diameter about 120 mm) was used as the semiconductor material. Two types of the supplying direction of the new fluid were performed: (1) a direction of about 90° to an imaginary line between the electrodes and the semiconductor material (disposing the fluid supplying ports at an one end side of the semiconductor material (this side of the paper) and disposing the discharging port at the other end side of the semiconductor material intervening the imaginary line (the far side of the paper) in FIG. 1) (2) a direction toward the semiconductor material from the electrodes in substantially a parallel direction to the imaginary line. The fluid (pure water) was supplied continuously into the liquid (pure water) at a flow rate of about 40 L/min. and drawn and removed from the discharging port. It was continuously supplied toward the vicinity of the electrodes, the application part of the discharged pulse to the semiconductor material, the semiconductor material fragmented by the application of the discharged pulse and the vicinity thereof (the supply amount of the pure water to the water bath and the discharge amount were in a range of substantially the same fixed amount within a unit time). The semiconductor material was fragmented into size having a maximum side length of about 30 mm. The fragmented objects were collected from the liquid and dried to measure the surface impurities.

The concentration of contamination of the electrode part material on the surface of the fragmented material was analyzed by the ICP-MS (inductive coupling plasma mass spectrometry) method as in Example 2.

The number of samples was five (n=5); the minimum value and the maximum value were shown.

**[Table 4]**

| | Direction of Fluid (1) | Direction of Fluid (2) |
|---|---|---|
| Concentration of Impurities on Surface of Fragmented Object (ppbw) | 0.006-0.011 | 0.023-0.086 |

Regarding the direction of supplying the new fluid when fragmenting by the high-voltage pulse, depending on the direction when the direction of the fluid is parallel to the imaginary line between the electrode parts and the semiconductor material, there is a possibility of that the concentration of impurities is uneven by the abrasion chips of the electrode parts deriving and spreading into the fluid or the liquid adhere on the surface of the fragmented objects or are taken into the surface of the fragmented objects. As known from the result in Table 4, in order to reduce them stably, preferably, the supplying direction of fluid is preferably a different direction from the direction toward the fragmented objects (the semiconductor material). It is desirable to draw and discharge in a case in which the liquid in the vessel and the supplied fluid are discharged to the supply direction of the new fluid. By drawing and discharging, it is possible to form the flow of the new fluid with efficiency.

Iron was used as the material of the electrode parts used for applying the high-voltage pulse in the present invention; however, electric conductive material other than iron may be used if it is material of the electrode part which can apply the high-voltage pulse. For example, it may be the electrode parts of material such as silver or the like.

In the present invention, an integrated type electrode parts were used as a structure of the electrode parts; however, it may be a structure of the electrode parts configured from detachable members of the same material in which the electrode parts can be partly replaced such that only defects by abrasion of the electrode parts are replaced. As mounting/dismounting methods, for example, screwing, combination, welding or the like can be cited.

### Industrial Applicability

The present invention can be utilized when producing the semiconductor material lumps by fragmenting the semiconductor material such as a silicon rod or the like.

### Reference Signs List

- 1: Silicon rod (semiconductor material)
- 22, 23: Electrode parts
- 30: Supplying nozzle
- 31: Supplying port
- 32: Discharging pipe
- 33: Discharging port

## Claims

1. A method of fragmenting or a method of generating cracks in semiconductor material wherein in a method of fragmenting the semiconductor material or a method of generating cracks in the semiconductor material by applying a high-voltage pulse on the semiconductor material disposed in liquid, a new fluid is continuously supplied toward at least one of a part on which the high-voltage pulse is applied in the semiconductor material and the electrode parts.

2. The method of fragmenting or the method of generating cracks in semiconductor material according to claim 1, wherein the new fluid is continuously supplied and the new fluid and a part of the liquid is drawn and discharged from the liquid.

3. The method of fragmenting or the method of generating cracks in semiconductor material according to claim 1 or 2, wherein the new fluid is also supplied to semiconductor material after the high-voltage pulse is applied.

4. The method of fragmenting or the method of generating cracks in semiconductor material according to any one of claims 1 to 3, wherein at least a part of the new fluid is flowed in a direction different from a direction toward the semiconductor material in an imaginary line in which a distance between a tip end of the electrode parts and the semiconductor material is minimum.

5. The method of fragmenting or the method of generating cracks in semiconductor material according to any one of claims 1 to 4, wherein after the new fluid is supplied to a part to which the high-voltage pulse is applied or the electrode parts or the semiconductor material after the high-voltage pulse is applied, at least a part of the new fluid is discharged along with liquid from a system.

6. The method of fragmenting or the method of generating cracks in semiconductor material according to any one of claims 1 to 5, wherein the liquid and the fluid are water or pure water.

7. The method of fragmenting or the method of generating cracks in semiconductor material according to any one of claims 1 to 6, wherein the liquid and the fluid include bubbles.

8. The method of fragmenting or the method of generating cracks in semiconductor material according to any one of claims 1 to 7, wherein the semiconductor material is polycrystalline silicon to be raw material for producing monocrystalline silicon.

9. A method of manufacturing semiconductor material lumps comprising:
a forming step of a rod-shape material forming semiconductor material into a rod; and
a fragmenting step fragmenting the semiconductor material by the fragmenting method of the semiconductor material according to any one of claims 1 to 7 or fragmenting the semiconductor material by a mechanical method after cracks are generated, into semiconductor material lumps.
